# EUROPÄISCHE PATENTANMELDUNG

(11) **EP 4 845 312 A1**
(43) Veröffentlichungstag der Anmeldung: **25.11.2026**
(21) Anmeldenummer: 26181159.0
(22) Anmeldetag: 26.05.2026
(51) Int. Cl.: H05K 1/02

(54) **KOMBINATION VON STROMSCHIENENTECHNIK MIT STANDARDLEITERPLATTENTECHNIK ZUR KONTAKTIERUNG VON LEISTUNGSBAUELEMENTEN**

(30) Priorität: 23.05.2025 DE 102025120340; 28.08.2025 DE 102025134515
(71) Anmelder: Computersysteme Dr. Schmidt GmbH, 02692 Doberschau OT Grubschütz (DE)
(72) Erfinder: Hermsdorf, Marcus, 01900 Großröhrsdorf (DE); Krostack, Bernd, 02791 Oderwitz (DE)
(74) Vertreter: Schied, Sebastian

(57) **Zusammenfassung**

Aufgabe der vorliegenden Erfindung ist es, einen kostengünstigen Aufbau zur maschinellen, automatisierten Herstellung von Hochstromleiterplatten unter Beachtung eines optimierten Wärmemanagements dieser Leiterplatten zu ermöglichen.

Die Erfindung betrifft eine Kombination der Stromschienentechnik mit der Standardleiterplattentechnologie zur Kontaktierung von Leistungsbauelementen (3). Die Leistungskontakte (9) dieser Leistungsbauelemente (3) sind mittels Verbindungsstellen (5) direkt auf mindestens einer Stromschiene (2) platziert und verbunden. Dabei ist die Leiterplatte (4) entweder auf der gleichen Seite wie die Leistungsbauelemente (3) platziert. In diesem Fall ist für das Leistungsbauelement (3) eine Aussparung (10) in der Leiterplatte (4) vorgesehen. Oder die Leiterplatte (4) befindet sich auf der gegenüberliegenden Seite der Stromschiene (2) wie das Leistungsbauelement (3). Die Steuerkontakte (8) können mit einer Verbinder-Leiterplatte (6) oder mit einer Verbinder-Stromschiene mit der Leiterplatte (4) verbunden sein, oder die Verbindung zur Leiterplatte (4) erfolgt über eine aufgetrennte Durchkontaktierung (7) oder mit SMD-Bauelement(en) (11). Oder die Steuerkontakte (8) sind abgewinkelt und überbrücken den Abstand zwischen Leiterplatte (4) und Leistungsbauelement (3).

Zwischen Leiterplatte (4) und Stromschiene (2) können Verbindungselemente (1) vorgesehen sein.

## Beschreibung

Die Leistungselektronik verlangt elektronischen Baugruppen viel ab. Nicht nur dass die Geräte-Generationen immer kleiner, leistungsfähiger und wirtschaftlicher werden müssen, auch die Anschlusstechnik ist zunehmend gefordert, muss sie doch hohe Ströme zuverlässig übertragen und eine mechanisch stabile Verbindung zur Platine sichern. Die Elektronik bietet vielfältige Techniken und ausgefeilte Komponenten, die wiederum eine geeignete Aufbau- und Verbindungstechnik bzw. entsprechende Leiterplatten benötigen. Bei dieser Hochstromleiterplatte sind anwendungsspezifische Stromschienen aus Kupfer mit konventionellem Leiterplattenaufbau kombiniert. Die Hochstromleiterplatte verbindet somit Leistungs- und Steuerelektronik in einem System.

Die zunehmenden Anwendungen für Leistungselektronik und die Verfügbarkeit von Bauelementen mit immer höherer Stromtragfähigkeit, erfordern auch neue Möglichkeiten der Kontaktierung dieser Bauelemente. Neben der Kontaktierung ist die Wärmeableitung der Eigenerwärmung dieser Bauelemente ein zentrales Problem. Weiterhin ist die Mischung der Leistungsbauelemente mit den Steuerbauelementen, die viel sensibler sind und kleinere Abstände besitzen, eine Herausforderung an die Leiterplatte und deren Fertigungsprozess.

Die Leiterplattenbranche hat anwendungsspezifische Technologien entwickelt, wie z. B. die Inlay- oder Dickkupfer-Technologie. Die Nachteile dieser Technologien sind das nicht optimierte Wärmemanagement - die Kupferschicht liegt isoliert mittig zwischen den Außenlagen - und die deutlich höheren Kosten gegenüber der Standard-Leiterplatte. Bis ein Produkt Marktreife erlangt, sind oft mehrere Iterationen notwendig. Hohe Leiterplattenkosten und einmalig anfallende Rüstkosten für Prototypen können dann das Entwicklungs-Budget gefährden.

Als naheliegender Stand der Technik der Erfindung wurde eine Vielzahl von Schriften ermittelt. So wird in der Schrift DE 10 2005 014 413 A1 eine Anordnung zur Wärmeableitung an einer Leiterplatte beschrieben, wobei die Leiterplatte mindestens ein elektrisches und/oder elektronisches Bauelement besitzt und eine Stromzuführungseinheit das Bauelement mit elektrischer Energie versorgt. Die Stromzuführungseinheit und das elektrische und/oder elektronische Bauelement sind elektrisch kontaktiert und thermisch gekoppelt. Die Stromzuführungseinheit dient zusätzlich zur Ableitung der thermischen Verlustleistung des Bauelements. Die Stromzuführungseinheit kann Kühlrippen aufweisen. Weiterhin kann die Stromzuführungseinheit als Stromschiene mäanderförmig ausgebildet sein.

In der Schrift DE 10 2010 013 334 A1 wird eine Leiterplatte mit einem elektrischen Bauelement beschrieben, welches auf eine metallische Trägerplatte aufgelötet ist. Die Trägerplatte ist trapezförmig ausgebildet und abgewinkelt und greift mit diesen Abwinklungen in Aussparungen der Leiterplatte und liegt mit ihrer Rückseite an der Leiterplatte an. An der Trägerplatte kann ein Kühlkörper angeklebt sein.

In einer weiteren Schrift, der DE 10 2014 118 655 A1 weist ein oberflächenmontierbares Kontaktelement für eine Leiterplatte eine unterseitige Kontaktfläche zur Auflage auf der Leiterplatte auf, und die Kontaktfläche weist außenseitig mindestens zwei benachbart angeordnete Rücksprünge auf. Eine Leiterplatte weist mindestens ein Kontaktelement auf, wobei die Leiterplatte mindestens eine Leitungsstruktur aufweist, an welcher das mindestens eine Kontaktelement angebracht ist. Bei einem System mit mindestens einer Leiterplatte ist an mindestens einem Kontaktelement der Leiterplatte ein Stromleiter angeschlossen. Die Erfindung ist beispielsweise anwendbar auf elektrische Systeme von Fahrzeugen, z.B. zur Verwendung in Bordnetzen, insbesondere zur Verbindung mit mindestens einer Stromschiene.

In der Schrift DE 10 2017 207 684 A1 wird eine Anordnung mit zumindest einer Leiterplatte und mindestens einem Halbleiterbauelement auf der Leiterplatte, mit einem ersten Kühlkörper, der auf einer Seite der Leiterplatte angeordnet ist und auf Abstand zur Leiterplatte liegt, wobei zwischen der Leiterplatte und dem Kühlkörper mindestens ein Abstandselement angeordnet ist, beschrieben und dass ein zweiter, separat von dem ersten ausgebildeter Kühlkörper auf der gegenüberliegenden Seite der Leiterplatte angeordnet ist und auf Abstand zur Leiterplatte liegt, wobei zwischen der Leiterplatte und dem zweiten Kühlkörper ebenfalls mindestens ein Abstandselement angeordnet sind, und dass mindestens ein Kühlkörper elektrisch leitend ausgebildet und das Halbleiterbauelement ) mit dem Kühlkörper elektrisch verbunden ist.

Die Anmeldung DE 10 2019 204 639 A1 beschreibt eine Leiterplatte für ein Leistungsmodul, umfassend eine Leiterschicht; eine Trägerschicht; und eine Isolierschicht, die zwischen der Leiterschicht und der Trägerschicht angeordnet ist; wobei eine erste Stromschiene an einer von der Trägerschicht abgewandten Oberseite der Leiterschicht elektrisch leitend befestigt ist, wobei die Leiterplatte mit einem zwischen einer zweiten Stromschiene, die an einer von der Leiterschicht abgewandten Seite der ersten Stromschiene mit dieser kontaktiert ist, und der Leiterschicht fließenden Strom beaufschlagbar ist, wobei die erste Stromschiene derart geformt ist, um einen Spalt zwischen der zweiten Stromschiene und der Leiterschicht zu bilden. Die Trägerschicht ist vorzugsweise aus einem Metall gebildet, etwa Aluminium, Kupfer, Edelstahl. Die Isolierschicht zwischen der Leiterschicht und der Trägerschicht wird vorzugsweise aus einem Polymermaterial und/oder einem Keramikmaterial hergestellt.

Die Erfindung DE 10 2022 202 817 A1 bezieht sich auf eine Vorrichtung zur Entwärmung mindestens eines elektronischen Bauelements einer Leiterplatte über ein Wärmeübertragungsmaterial an eine Wärmesenke. Die Wärmesenke des mindestens einen elektronischen Bauelements ist mindestens eine Zuleitungsstromschiene oder mindestens eine Ableitungsstromschiene. Des Weiteren bezieht sich die Erfindung auf ein Verfahren zur Entwärmung einer Leiterplatte mit mindestens einem elektronischen Bauelement, wobei zunächst mindestens eine Stromschiene angeordnet wird, ein Bestücken der Leiterplatte mit zumindest einem elektronischen Bauelement in Gestalt eine MosFETs oder eines Slug-Up-MosFETs erfolgt, anschließend eine Ausbildung einer Schicht eines Wärmeübertragungsmaterials in einer Schichtdicke auf der mindestens einen Stromschiene vorgenommen wird und ein Verbinden der Leiterplatte des Wärmeübertragungsmaterials und der mindestens einen Stromschiene in Aufpressrichtung mit Einpressstiften erfolgt, wobei die mindestens eine Stromschiene als Wärmesenke dient.

In der Schrift DE 11 2018 002 063 T5 wird eine mit einem Metallelement ausgestattete Leiterplatte beschrieben, welche umfasst: eine gedruckte Leiterplatte, die ein Durchgangsloch aufweist; ein Metallelement, das einen Schaftabschnitt, der in das Durchgangsloch eingesetzt ist, und einen Kopfabschnitt umfasst, der außerhalb des Durchgangslochs angeordnet ist, wobei der Kopfabschnitt einen Durchmesser aufweist, der größer als ein Durchmesser des Durchgangslochs ist, und ein leitfähiges Verbindungsmaterial zum Verbinden des Schaftabschnitts und einer Innenwandung des Durchgangslochs miteinander.

Die Schrift DE 11 2018 002 658 T5 beschreibt eine Spulenvorrichtung umfassend eine Spuleneinheit, die eine Spule und einen Magnetkern enthält, ein Gehäuse, das aus Kunststoff hergestellt ist und die Spuleneinheit aufnimmt, und eine Stromschiene, die einen Verbindungsabschnitt umfasst, die mit einem Leitungsweg einer Leiterplatte verbunden werden kann und die am Gehäuse anliegt. Das Gehäuse umfasst einen Montageabschnitt, der auf einer Hauptfläche der Leiterplatte montiert werden kann. Da die Stromschiene an dem Gehäuse anliegend gehaltert bzw. gehalten ist, ist es außerdem möglich, Wärme in der Stromschiene auf das Gehäuse zu übertragen und Wärme von dem Gehäuse abzuleiten, wodurch die Wärmeableitung verbessert werden kann.

Die Erfindung WO 2023/151 751 A1 betrifft eine Invertervorrichtung für eine elektrische Antriebsmaschine eines Kraftfahrzeuges, mit einer eine erste Leiterstruktur aufweisenden DC-Eingangseinheit, einer eine zweite Leiterstruktur aufweisenden AC-Ausgangseinheit und einer zwischen der DC-Eingangseinheit und der AC-Ausgangseinheit eingesetzten, an die beiden Leiterstrukturen elektrisch angeschlossenen Leistungshalbleitereinrichtung, wobei die beiden Leiterstrukturen als voneinander getrennte laminierte Sammelschienen oder voneinander getrennte Stromleiter einer Hochstromleiterplatte ausgebildet sind.

Aufgabe der vorliegenden Erfindung ist es, einen kostengünstigen Aufbau zur maschinellen, automatisierten Herstellung von Hochstromleiterplatten unter Beachtung eines optimierten Wärmemanagements dieser Leiterplatten zu ermöglichen.

Die Erfindung betrifft eine Kombination der Stromschienentechnik mit der Standardleiterplattentechnologie zur Kontaktierung von Leistungsbauelementen. Es erfolgt also eine Vereinigung der Mehrlagen-Standard-Leiterplatte mit Metallelementen, z. B. aus Kupfer, den sogenannten Stromschienen. Die Stromschienen werden mit der Leiterplatte verbunden. Die Verbindungen bilden die thermische und elektrische Kontaktierung beider Elemente und sorgen für die notwendige mechanische Stabilisierung. Zur Verbindung werden Standardtechnologien verwendet. Passende Verbindungstechnologien ohne Verbindungselemente, wie Löten oder Laserschweißen, oder solche mit Verbindungselementen, wie Einpressen, Nieten oder Löten, werden anforderungsspezifisch gewählt. Die Verbindungselemente können beispielsweise gleichzeitig als Kabelanschluss dienen. Anwendungsspezifisch ergeben sich zwei Aufbauvarianten der Hochstromleiterplatte. Bei Variante A ist die Leiterplatte mit Aussparungen, z.B. Bohrung oder Ausfräsung, für die Leistungsbauelemente auf der gleichen Seite wie die Leistungsbauelemente auf den Stromschienen platziert. Variante B positioniert die Stromschienen auf die Leiterplatte. Die Leistungsbauelemente werden wiederum auf den Stromschienen platziert und verbunden. Die Verbindung der Leistungskontakte mit den Stromschienen erfolgt mit Standardtechnologien, z. B. Löten im Reflowprozess oder Laserschweißen. Dies hat den großen Vorteil, dass der Strom und die Wärme direkt über die Stromschienen geleitet werden. Bisherige Technologien leiten Strom und Wärme über viele Durchkontaktierungen verlustbehaftet zu den verstärkten Mittelschichten. Zur weiteren Erhöhung der Wärmeabgabe an die Umgebungsluft kann auf die plan gestaltbare Fläche der Stromschiene (elektrisch durch eine Wärmeleitfolie getrennt) ein Kühlkörper angebracht werden. Die Steuerkontakte werden mit der Leiterplatte durch geeignete Technologien, z. B. eine Verbinder-Leitplatte oder Stromschiene, Abwinkeln der Kontakte, SMD-Bauelemente bzw. direkt über aufgetrennte Durchkontaktierungen auf der Leiterplatte, verbunden. Durch die vorgenannten Technologien ist eine effiziente und automatisierte Fertigung der Baugruppen und damit Produkte in hoher Stückzahl möglich.

Ein Detail der Erfindung betrifft die Kontaktierung der Steueranschlüsse der Leistungsbauelemente. Diese haben durch die direkte Montage auf den Stromschienen keine Verbindung zur Leiterplatte. Für die effiziente Kontaktierung wurden mehrere Möglichkeiten entwickelt. Einmal die seitliche Galvanisierung der Leiterplattenwand durch eine aufgetrennte Durchkontaktierung, der Einsatz einer Verbinder-Leiterplatte bzw. Verbinder-Stromschiene(n), SMD-Bauelemente oder das Abwinkeln der Steuerkontakte. Die Verbinder-Leiterplatte passt in die Kontur der Stromschienen und verbindet über Lötpads die Leiterplatte mit den Steuerkontakten des Leistungsbauelementes. Alternativ verbinden die Verbinder-Stromschienen, mit Abstandshalter(n) in die Stromschienenkontur eingelegt, ebenfalls die Steuerkontakte mit der Leiterplatte. Bei Aufbauvariante B können zusätzlich SMD-Bauelemente als Verbindungselemente zwischen Leistungsbauelement und Leiterplatte dienen. Alternativ ermöglichen einige Gehäuseformen der Leistungsbauelemente das nachträgliche Abwinkeln der Steuerkontakte, um so die Lücke zur Leiterplatte zu überbrücken.

Die Vorteile der vorliegenden Erfindung sind: Eine verbesserte Wärmeableitung. Es gibt keine Thermo-Durchkontaktierungen. Die Wärme wird direkt über Stromschienen, Anschlusselemente, Leiterplatte, eventuell Kühlkörper und Kabel abgeführt. Anwendungsspezifisch ist damit z. B. eine weitere Miniaturisierung oder der Entfall von Kühlkörpern möglich. Die erfindungsgemäßen Hochstromsysteme sind bedeutend kostengünstiger gegenüber bisherigen Hochstromleiterplatten. Damit werden Prototypen in geringen Stückzahlen möglich. Gegenüber der Stromschienentechnik können einzelne Prozessschritte entfallen, z. B. eine Umspritzung zur mechanischen Stabilisierung. Gegenüber bisherigen Hochstromleiterplatten können Leiterplatten mit beliebigem Lagenaufbau verwendet werden. So wird z. B. die Verwendung von BGA-Bauelementen möglich.

Die vorstehend beschriebene Erfindung wird im Folgenden anhand von drei Ausführungsbeispielen näher erläutert. Es zeigen
Fig.1 eine Draufsicht auf eine erfindungsgemäße Hochstromleiterplatte Aufbauvariante A,
Fig.2 eine Schnittdarstellung der Hochstromleiterplatte an der in Fig.1 angedeuteten Schnittstelle,
Fig.3 eine Draufsicht auf eine Hochstromleiterplatte Aufbauvariante A mit aufgetrennter Durchkontaktierung,
Fig.4 eine Schnittdarstellung der Hochstromleiterplatte an der in Fig.3 angedeuteten Schnittstelle,
Fig.5 eine Draufsicht auf eine erfindungsgemäße Hochstromleiterplatte Aufbauvariante B und
Fig.6 eine Schnittdarstellung der Hochstromleiterplatte an der in Fig.5 angedeuteten Schnittstelle.

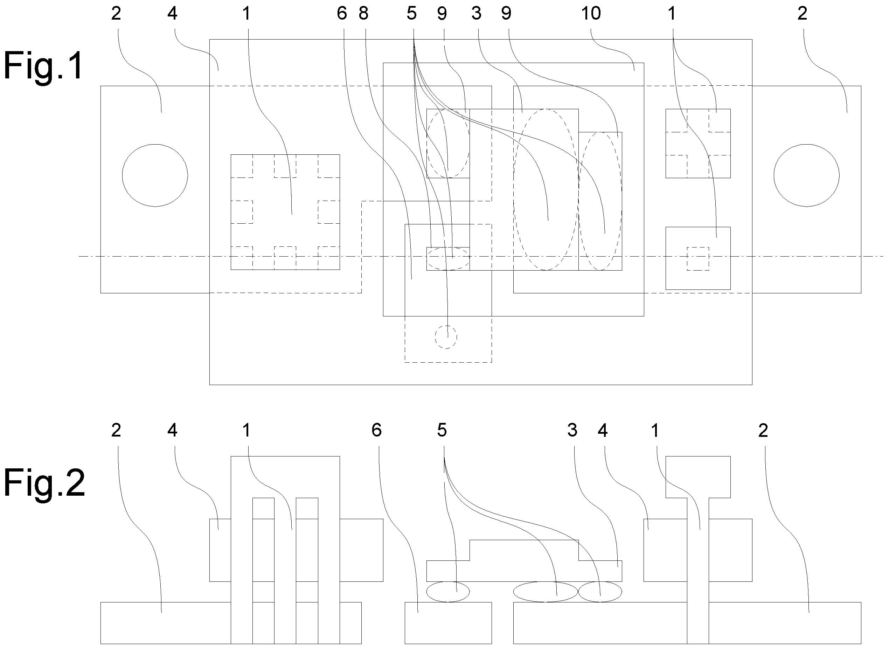

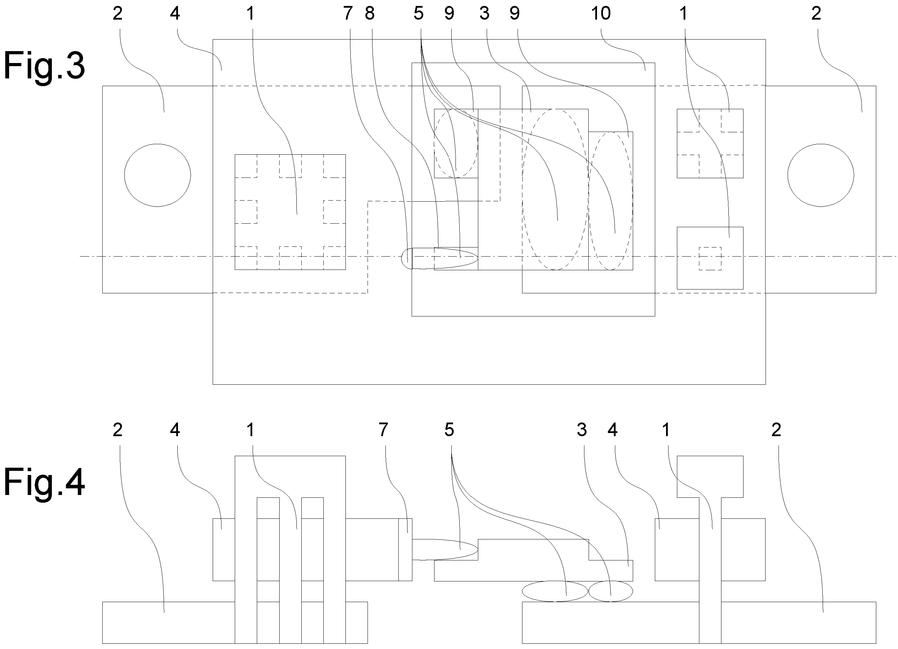

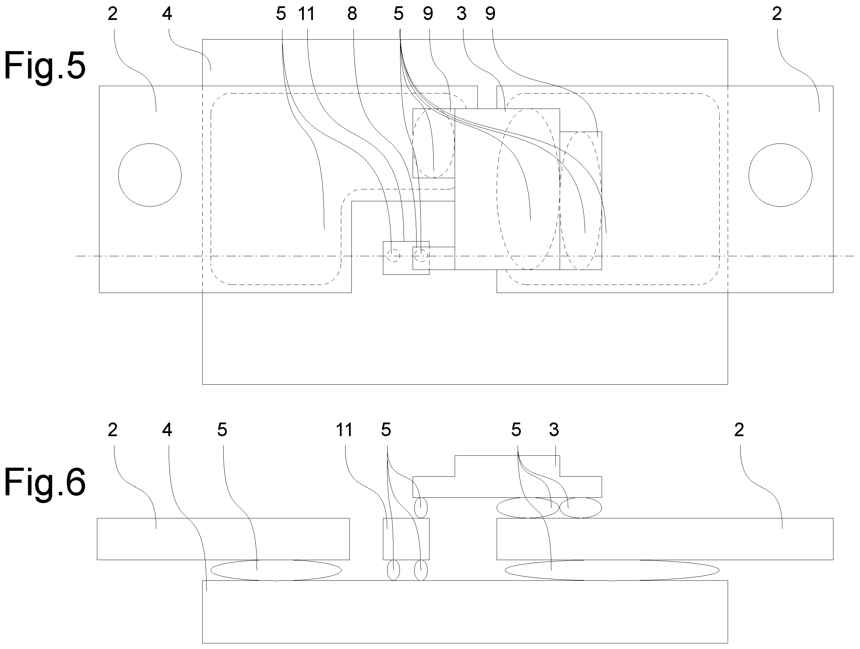

Unter (Fig.1 bis 4) bzw. über (Fig.5 und 6) der Leiterplatte (4) sind im Ausführungsbeispiel zwei voneinander getrennt liegende Stromschienen (2) angeordnet, die mit ihren Enden als elektrische Anschlussstellen aus der Leiterplatte (4) herausragen. Die Stromschienen (2) sind mit der Leiterplatte (4) verbunden. Verbindungselemente (1) können diese Verbindung realisieren. Ein Leistungsbauelement (3) ist direkt auf den Stromschienen (2) platziert und mit diesen verbunden. Bei Aufbauvariante A hat die Leiterplatte (4) eine entsprechende Aussparung (10). Der Steuerkontakt (8) ist in Fig.1 und Fig.2 über eine Verbinder-Leitplatte (6) mit der Leiterplatte (4) verbunden. In Fig.3 und Fig.4 erfolgt diese Verbindung direkt über eine aufgetrennte Durchkontaktierung (7). In Fig.5 und Fig.6 über ein SMD-Bauelement (11). Die Verbindungsstellen (5) zwischen je zwei Elementen sind in den Figuren besonders gekennzeichnet.

Der zweite Teil der Erfindung betrifft die Kontaktierung der Steuerkontakte (8) des Leistungsbauelementes (3), das durch Montage auf den Stromschienen (2) keine Verbindung zur Leiterplatte (4) besitzt. Folgende Möglichkeiten bestehen, um die Steuerkontakte (8) mit der Leiterplatte (4) zu verbinden:
Fig.1 und Fig.2 zeigen die Kontaktierung mittels Verbinder-Leiterplatte (6).

In Fig.3 und Fig.4 wird direkt die durch eine aufgetrennte Durchkontaktierung (7) entstehende seitliche Galvanisierung der Leiterplattenwand genutzt.

Alternativ können die Steuerkontakte (8) mit der Leiterplatte (4) über mindestens eine Verbinder-Stromschiene (mit Abstandshalter) verbunden sein.

Bei Aufbauvariante B können, wie in Fig.5 und Fig.6 ersichtlich, SMD-Bauelemente (11) als Verbinder genutzt werden.

Alternativ ermöglichen einige Gehäuseformen der Leistungsbauelemente (3) ein Abwinkeln der Steuerkontakte (8), um die Lücke zur Leiterplatte (4) zu überbrücken.

### Zusammenstellung der Bezugszeichen

- 1 -: Verbindungselemente
- 2 -: Stromschiene
- 3 -: Leistungsbauelement
- 4 -: Leiterplatte
- 5 -: Verbindungsstelle
- 6 -: Verbinder-Leiterplatte
- 7 -: aufgetrennte Durchkontaktierung
- 8 -: Steuerkontakt
- 9 -: Leistungskontakte
- 10 -: Aussparung der Leiterplatte
- 11 -: SMD-Bauelement

## Patentansprüche

1. Kombination von Stromschienentechnik mit Standardleiterplattentechnik zur Kontaktierung von Leistungsbauelementen (3),
**dadurch gekennzeichnet,**
**dass** die Leistungsbauelemente (3) mittels mindestens einer Verbindungsstelle (5) direkt auf mindestens einer Stromschiene (2) platziert und verbunden sind und mindestens ein Leistungskontakt (9) mit mindestens einer Stromschiene (2) verbunden ist und mindestens eine Leiterplatte (4) mit mindestens einer Stromschiene (2) verbunden ist.

2. Kombination von Stromschienentechnik mit Standardleiterplattentechnik nach Anspruch 1,
**dadurch gekennzeichnet,**
**dass** in einer Leiterplatte (4) mindestens eine Aussparung (10) für mindestens ein Leistungsbauelement (3) vorgesehen ist und diese Leiterplatte (4) auf der gleichen Seite der Stromschiene (2) wie das Leistungsbauelement (3) platziert ist.

3. Kombination von Stromschienentechnik mit Standardleiterplattentechnik nach Anspruch 1,
**dadurch gekennzeichnet,**
**dass** eine Leiterplatte (4) auf der gegenüberliegenden Seite der Stromschiene (2) wie das Leistungsbauelement (3) platziert ist.

4. Kombination von Stromschienentechnik mit Standardleiterplattentechnik nach Anspruch 1,
**dadurch gekennzeichnet,**
**dass** zwischen Leiterplatte (4) und je einer Stromschiene (2) mindestens ein Verbindungselement (1) vorgesehen ist.

5. Kombination von Stromschienentechnik mit Standardleiterplattentechnik nach Anspruch 1,
**dadurch gekennzeichnet,**
**dass** die Steuerkontakte (8) mit der Leiterplatte (4) über mindestens eine Verbinder-Leiterplatte (6) verbunden sind.

6. Kombination von Stromschienentechnik mit Standardleiterplattentechnik nach Anspruch 1,
**dadurch gekennzeichnet,**
**dass** die Steuerkontakte (8) mit der Leiterplatte (4) über mindestens eine Verbinder-Stromschiene, gegebenenfalls unter Zuhilfenahme von mindestens einem Abstandshalter, verbunden sind.

7. Kombination von Stromschienentechnik mit Standardleiterplattentechnik nach Anspruch 1,
**dadurch gekennzeichnet,**
**dass** die Steuerkontakte (8) mit der Leiterplatte (4) über eine seitliche Galvanisierung der Leiterplattenwand, entstanden durch eine aufgetrennte Durchkontaktierung (7), verbunden sind.

8. Kombination von Stromschienentechnik mit Standardleiterplattentechnik nach Anspruch 1 und 3,
**dadurch gekennzeichnet,**
**dass** mindestens ein Steuerkontakt (8) mit der Leiterplatte (4) über ein SMD-Bauelement (11) verbunden ist.

9. Kombination von Stromschienentechnik mit Standardleiterplattentechnik nach Anspruch 1 und 3,
**dadurch gekennzeichnet,**
**dass** mindestens ein Steuerkontakt (8) abgewinkelt ist, sodass dadurch der Abstand Leistungsbauelement (3) zur Leiterplatte (4) überbrückt wird und damit dieser Kontakt über einer Verbindungsstelle (5) mit der Leiterplatte (4) verbunden ist.
